# DEMANDE DE BREVET EUROPEEN

(11) **EP 0 588 721 A1**
(43) Date de publication de la demande: **23.03.1994**
(21) Numéro de dépôt: 93402255.9
(22) Date de dépôt: 16.09.1993
(51) Int. Cl.: H01L 21/3205, H01C 13/02, H01C 7/00

(54) **Support à réseau d'éléments résistifs en polymère conducteur et son procédé de fabrication**

(30) Priorité: 18.09.1992 FR 9211149
(71) Demandeur: COMMISSARIAT A L'ENERGIE ATOMIQUE, F-75015 Paris (FR)
(72) Inventeur: Geffroy, Bernard, F-94240 L'Hay les Roses (FR); Ngo, Christian, F-91140 Villebon-sur-Yvette (FR); Rosilio, André, F-92160 Antony (FR); Rosilio, Charles, F-91190 Gif sur Yvette (FR); Devos, Francis, F-91620 La Ville du Bois (FR)
(74) Mandataire: Dubois-Chabert, Guy

(57) **Abrégé**

Selon l'invention le réseau d'éléments résistifs (6a) est réalisé en polymère organique dopé par un anion, conducteur électronique. Ce réseau est en particulier formé sur un circuit intégré (2) comportant des plots métalliques (4) affleurants.

## Description

L'invention se rapporte à un support pourvu d'un réseau d'éléments résistifs réalisé en polymère conducteur électronique ainsi que son procédé de fabrication. Ces éléments ont une largeur allant du micromètre à quelques dizaines de micromètres.

L'invention s'applique en particulier dans les domaines de l'électronique et de l'optoélectronique.

Dans ce type d'application, le réseau d'éléments résistifs est déposé sur un circuit intégré (réalisé sur silicium ou autres matériaux semiconducteurs) qui possèdent des pavés métalliques réalisant des contacts électriques avec les éléments du réseau résistif. Ces pavés font partie d'un ensemble électronique qui ne concerne pas l'invention. Le réseau permet notamment d'apporter des fonctions nouvelles au dispositif électronique et donc d'améliorer certaines de ses possibilités ou performances.

Un exemple concret de dispositifs électroniques auxquels l'invention s'applique est celui des rétines électroniques.

Dans l'application particulière des rétines électroniques, le réseau résistif est destiné à la réalisation d'un réseau cellulaire, c'est-à-dire d'une rétine dite intelligente, à processeur associé, comme décrit dans le document (1) P. Garda, A. Reichart, H. Rodriguez, F. Devos et B.Zavidovique, Traitement du signal vol.5, n°6 (1988) pp.435-449, "Une rétine électronique automate cellulaire".

Ces rétines intelligentes sont constituées d'un ensemble de processeurs élémentaires réalisant (éventuellement) la détection de la lumière, un stockage de l'information (le plus souvent sous deux niveaux de gris) et un certain traitement.
Chaque processeur correspond à un pixel. Un pavé métallique ou borne conductrice peut être associé à chaque pixel.

On peut, grâce au circuit électronique intégré, amener chacun de ces pavés à un potentiel électrique ou encore leur faire débiter un courant. Grâce au réseau résistif, on obtient alors une carte de courants (respectivement de potentiels qui peuvent être dynamiques ou statiques), représentant l'image transformée.

La différence entre l'image initiale et l'image diffusée par le réseau résistif permet, par exemple, d'extraire un contour, un mouvement, etc. D'autres opérations analogiques plus ou moins basées sur la convolution des signaux électriques fournis par le circuit intégré et le réseau résistif sont également possibles. De fait, le réseau résistif peut fournir de nouveaux opérateurs électroniques pour le traitement d'image.

Ceci est un exemple typique d'utilisation d'un réseau résistif selon l'invention mais on peut en imaginer d'autres utilisant des systèmes électroniques différents.

réseau résistif joue, avec ses capacités membranaires, le rôle d'un filtre spatio-temporel paramétrable présentant certaines similitudes avec ce qui existe dans l'oeil.

Cette analogie a conduit certains chercheurs (voir à ce sujet (2) l'article de D. Marr et E. Hildreth, Proc. R. Soc. Lond.B207 (1980) 187-217, "Theory of edge detection") à proposer des mécanismes cellulaires de traitement d'images basés sur de tels réseaux résistifs. Le système de calcul développé à ce propos est basé sur des mécanismes de diffusion, si possible gaussiens, qui permettent de réaliser certaines opérations mathématiques. Celles-ci sont basées sur l'opération de convolution par un noyau isotrope ou non sur la différence entre l'image initiale et l'image diffusée par le réseau résistif.

Ce type d'opération permet de réaliser des filtres passe-haut, passe-bas, des détecteurs de bords, de mouvements, etc. ainsi que toute combinaison des opérations précédentes.

L'intérêt de rapporter un réseau d'éléments résistifs sur un dispositif électronique est important dans le cas d'une technologie CMOS car on ne peut pas le réaliser par simple aménagement d'une technologie de fabrication classique. Il faudrait notablement modifier les procédés industriels existants, ce qui est, commercialement parlant, une chose difficilement pensable.

La solution adoptée à ce jour pour réaliser le réseau résistif utilise des ensembles de transistors créés lors de la fabrication de la rétine. Ceux-ci n'ont un comportement résistif linéaire que dans des conditions très contraignantes d'utilisation et nécessitent, en moyenne, de 6 à 8 transistors par résistance. Ceci va à l'encontre de l'augmentation de la densité d'intégration de ces circuits.

Globalement, on peut dire que la réalisation de réseaux résistifs mobilise une partie du circuit intégré qui pourrait être utilisée à d'autres fonctions. Ceci justifie donc pleinement l'intérêt de l'invention proposée.

L'invention a donc pour objet un support pourvu d'un réseau d'éléments résistifs ainsi que son procédé de fabrication permettant notamment de remédier aux inconvénients ci-dessus. Elle permet en particulier de simplifier la conception des circuits intégrés destinés à recevoir ce réseau d'éléments résistifs par suppression des transistors simulant les éléments résistants, typiquement plusieurs dizaines de milliers de transistors par centimètre carré. Ceci permet l'intégration de nouvelles fonctions sur le même circuit intégré et l'augmentation des performances électriques.

Par ailleurs, l'invention permet la réalisation d'un réseau d'éléments résistifs linéaires sur une large gamme de dimensions en utilisant une technologie non corrosive et peu coûteuse. Ainsi, le réseau résistif de l'invention peut être rapporté sans dommage sur des circuits électroniques déjà passivés.

De plus, la fabrication de ce réseau résistif utilise des produits du commerce peu chers et ne nécessite pas de matériel très sophistiqué. D'autre part, les produits chimiques utilisés peuvent être choisis pour ne pas présenter de danger particulier concernant la toxicité et la pollution de l'environnement.

L'originalité de l'invention réside dans l'utilisation de polymère organique conducteur électronique (photo-structuré) comme réseau résistif. Ce réseau résistif peut présenter des dimensions microniques voir submicroniques et être réalisé, sans gravure de matériau.

L'invention proposée est basée sur l'association de deux technologies différentes, celle des circuits électroniques intégrés et celle des polymères conducteurs. Cette association permet la réalisation de dispositifs électroniques possédant de nouvelles fonctions.

Les polymères organiques conducteurs de l'électricité connus sont essentiellement utilisés pour leurs propriétés électrochimiques dans des générateurs électrochimiques ou des cellules électrochromes.

Plus récemment, on a envisagé d'utiliser les polymères organiques conducteurs électroniques dans des diodes, des transistors à effet de champ, des éléments de mémoire optique comme décrit dans l'article (3) de K. Yoshino, R.I. Sugimoto, J.G. Rabe et W.F. Schmidt, Japanese Journal of Applied Physics vol.24 n°1 (1985) pp.L33-L34, "Optical Spectra change in conducting polymer due to insulator-metal transition induced by light irradiation and proposal as optical memory element" ou l'article (4) de K. Kaneto, T. Asano et W. Takashima, Japanese Journal of Applied Physics, vol.30, n°2A de février 1991, pp. L215-L217, "Memory device using a conducting polymer and solid polymer electrolyte".

De façon plus précise, l'invention a pour objet un support pourvu d'un réseau d'éléments résistifs, dans lequel les éléments résistifs sont réalisés en polymère organique photostructuré dopé par un anion, conducteur électronique.

Les polymères conducteurs électroniques utilisables dans l'invention sont de différents types. Ils peuvent consister en des homopolymères ou copolymères. Ils sont généralement formés à partir de monomères aromatiques, de composés hétérocycliques qui sont ou non substitués par divers groupements.

Les polymères conducteurs résultent en particulier de la polymérisation ou copolymérisation de monomères tels que le pyrrole, le thiophène, l'aniline, le benzène, le furanne et les dérivés de ces monomères comme par exemple le bithiophène, les alkyles pyrroles ou alkyles thiophènes dans lesquels le radical alkyle comporte de 1 à 12 atomes de carbone, la para(aminodyphénylamine) ou encore les dérivés ortho de l'aniline.

Les polymères et copolymères à base de pyrrole, de thiophène, d'aniline, d'alkyle thiophène ou de benzène sont les plus intéressants du point de vue stabilité. On les utilisera préférentiellement.

En principe, tous les polymères ou copolymères conducteurs électroniques peuvent être utilisés pour constituer les réseaux résistifs. Néanmoins, la nécessité de réaliser des motifs aux dimensions microniques demande des mises en oeuvre particulières qui peuvent limiter le choix des polymères.

Ce choix est encore réduit si l'on veut un procédé de fabrication de ces polymères qui soit le moins corrosif possible pour le substrat électroniquement actif sur lequel on souhaite réaliser le réseau résistif. Ceci est notamment le cas pour le pyrrole, le thiophène et leurs composés alkylés.

Les polymères conducteurs sont obtenus à partir de monomères polymérisables par oxydation chimique. Généralement, l'agent oxydant joue en même temps le rôle de dopant ce qui rend le polymère conducteur.

On peut toutefois utiliser un mélange composé d'un oxydant et d'un dopant.

Les monomères polymérisables par oxydation chimique qui sont stables à l'air sont ceux déjà cités plus haut.

Les agents oxydants utilisés pour la polymérisation et le dopage du polymère dépendent de la nature du monomère. Par exemple, pour le pyrrole, on peut utiliser tout oxydant dont le potentiel d'oxydation par rapport à l'électrode d'hydrogène est supérieur à 0,8 V. C'est le cas des sels ferriques et des sels cériques, des persulfates, des vanadates, des permanganates et des bichromates des ions alcalins ou d'ammonium. Ces oxydants peuvent aussi être utilisés dans le cas de l'aniline et du thiophène.

L'oxydation peut avoir lieu en solution dans un milieu aqueux ou organique ou en phase vapeur.

L'invention a aussi pour objet un procédé de fabrication d'un réseau d'éléments résistifs sur un support, consistant à photostructurer sur le support un polymère organique localement dopé par un anion et conducteur électronique.

Deux techniques sont utilisables dans l'invention pour fabriquer le réseau d'éléments résistifs.

Selon une première technique, on effectue les étapes suivantes :
a)- dépôt sur le support d'un polymère organique hôte contenant un agent oxydant photoréductible,
b)- insolation du polymère à travers un masque définissant l'emplacement et la forme des éléments, réduisant ainsi dans les zones du polymère insolées l'oxydant, et
c)- mise en contact du polymère hôte insolé avec au moins un monomère polymérisable et oxydable chimiquement par ledit agent, afin de rendre les zones du polymère non insolées, conductrices.

L'étape c) peut être réalisée en mettant le polymère hôte insolé au contact de vapeurs du monomère polymérisable ou en trempant ce polymère hôte dans une solution du monomère.

Cette première technique permet la réalisation d'un réseau d'éléments résistifs qui est l'image négative du masque utilisé.

Selon une second technique, on effectue les étapes suivantes :
A) dépôt sur le support d'un polymère dopé apte à conduire électroniquement et contenant un composé photosensible apte à engendrer un dopant de ce polymère,
B) insolation du polymère dopé apte à conduire à travers un masque définissant l'emplacement et la forme des éléments, engendrant ainsi le dopant dans les zones du polymère insolées et les rendant conductrices.

Cette seconde technique permet l'obtention d'un réseau résistif qui est l'image positive du masque.

Dans cette seconde technique, le polymère utilisable dans l'étape A) est peu ou pas conducteur. Sous l'action de la lumière, le dopant est engendré uniquement dans les zones insolées rendant ainsi le polymère conducteur.

Pour fabriquer un réseau d'éléments résistifs sur un support, il faut pouvoir déposer un film mince homogène et d'épaisseur contrôlée sur celui-ci.

Ainsi, les films de polymère contenant l'agent oxydant photoréductible ou le composé photosensible sont formés avantageusement au cours d'une rotation rapide du support sur lequel est déposées une ou quelques gouttes d'une solution selon la méthode dite de la "tournette". Il est toutefois possible de déposer ce film de polymère par une autre méthode comme le trempage du support dans une solution appropriée de polymère.

Le dépôt de polymère sur le support est effectué à température ambiante.

Afin de stabiliser le réseau résistif obtenu, on effectue avantageusement un recuit du polymère conducteur obtenu, à une température de 60 à 120°C pendant quelques minutes. Ce traitement est peu contraignant et peut être utilisé même lors de la réalisation de dispositifs électroniques fragiles.

Dans le cas particulier de la réalisation de dispositifs électroniques, le support est un substrat semi-conducteur. Il peut être en silicium monocristallin ou polycristallin, en CdTe, en GaAs, InP etc.. En outre, ce support est équipé de bornes conductrices affleurant, connectées aux éléments résistifs.

L'invention concerne aussi un circuit intégré et en particulier une rétine électronique artificielle, pourvu de bornes conductrices et d'éléments résistifs connectés à ces bornes, dans lequel les éléments résistifs sont réalisés en polymère organique photostructuré dopé par un anion, conducteur électronique.

D'autres caractéristiques et avantages de l'invention ressortiront mieux de la description qui va suivre, donnée à titre illustratif et non limitatif, en référence aux figures annexées, dans lesquelles :

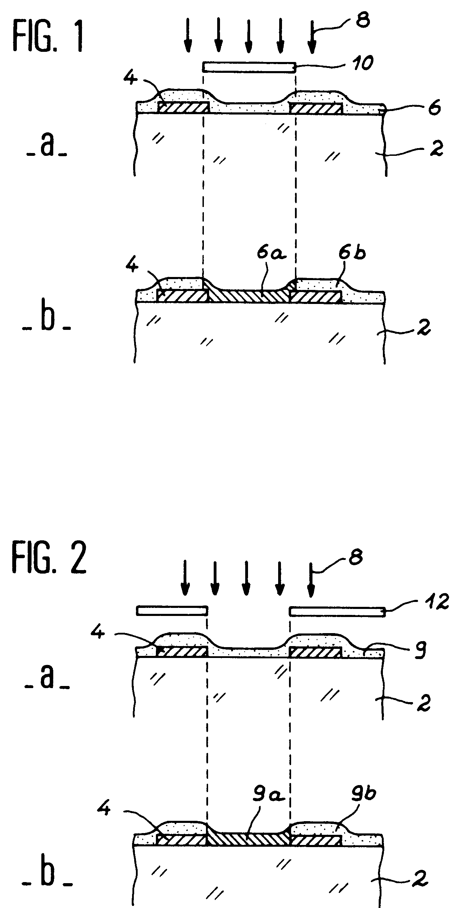

- les figures 1 et 2 représentent schématiquement, selon deux variantes, les étapes de fabrication d'un réseau résistif conforme à l'invention.

La description qui suit se rapporte à l'élaboration d'un réseau d'éléments résistifs qui peut être déposé sur une rétine électronique artificielle comme celle proposée dans la référence 1. Cette rétine est un circuit intégré dont la surface est de l'ordre du centimètre carré et comporte des pavés ou bornes métalliques sur lesquels il faut prendre des contacts électriques ; la taille des pavés peut aller de 5 à 10 µm et la distance entre eux peut aller de 50 à 100 µm.

La réalisation de ce réseau résistif selon une première variante est illustrée sur les parties a et b de la figure 1.

On effectue tout d'abord (figure 1a), sur le circuit intégré 2 pourvu de ses pavés métalliques 4 affleurant à sa surface, le dépôt d'un film mince 6 de polymère ou copolymère hôte généralement isolant renfermant un agent oxydant photoréductible, qui peut être réduit par insolation.

Le dépôt du film mince 6 de polymère ou de copolymère est effectué selon la méthode dite à la "tournette". Pour ce faire, le polymère hôte est dissous dans un solvant approprié, fonction du polymère et de la nature du support, et contenant l'ion photoréductible.

On insole alors à l'aide d'une iumière visible et/ou ultraviolette 8 le film de polymère 6 à travers un masque 10 représentant l'image négative du réseau résistif en polymère conducteur à réaliser. Ce masque 10 est en particulier un masque mécanique légèrement au contact du film de polymère ; il peut éventuellement masquer partiellement les pavés 4 mais ce n'est pas nécessaire.

Dans les zones 6b de polymère, insolées, l'agent photoréductible est alors réduit alors que dans les zones 6a masquées l'agent oxydant reste intact.

On effectue alors l'immersion de l'échantillon obtenu dans des vapeurs de monomère oxydable et polymérisable par l'agent oxydant. Celles-ci, au contact de l'oxydant se polymérisent et se dopent. La structure obtenue est alors celle de la partie b de la figure 2. Les zones masquées 6a deviennent alors conductrices alors que les zones insolées 6b restent isolantes.

On effectue alors un recuit entre 60°C et 120°C pendant quelques minutes pour stabiliser le réseau résistif.

On donne ci-après des exemples précis de réalisation du réseau d'éléments résistifs selon le procédé décrit en référence à la figure 1.

### EXEMPLES

Le polymère hôte utilisé peut être, soit du PVC (chlorure de polyvinyle) ou du VYNS (copolymère de PVC et d'acétate de vinyle) dissous dans de la cyclohexanone ou du THF (tétrahydrofuranne), soit du PVA (polyvinylalcool) ou PEO (polyoxy-éthylène) dissous dans l'eau à raison de 100 à 200 g/litre. L'oxydant peut être du chlorure ferrique ou du tosylate ferrique ou du phénol sulfonique ferrique et sa concentration peut varier entre 100 et 200 g/litre.

D'autres oxydants sont possibles mais ils doivent pouvoir être réduits par la lumière. C'est le cas, par exemple, des sels cériques.

Pour réaliser le film hôte 6 la vitesse de rotation du circuit intégré 2 est comprise entre 2000 et 5000 tours/min et le temps de rotation est d'environ 60 s. Ceci permet de réaliser des films dont l'épaisseur varie de 1 µm à 3 µm.

La deuxième étape est l'irradiation 8 du film au travers du masque 10 convenablement positionné par rapport à la rétine. Ce positionnement se fait à l'aide d'un appareil approprié et l'irradiation est effectuée avec une lampe haute pression à vapeur de mercure opérant dans le visible et l'ultraviolet placée à 10 cm de l'échantillon. La puissance délivrée est de l'ordre de 50 watts/cm² et le temps d'irradiation varie de 1 à 5 min.

Dans la troisième étape, l'échantillon est mis dans des vapeurs de pyrrole pendant un temps compris entre 1 et 10 min. Le pyrrole, au contact de l'oxydant encore présent dans les zones masquées 6a de l'échantillon, se polymérise et se dope à la fois. On peut aussi réaliser cette étape par trempage dans du pyrrole dissous dans du THF.

On termine par un recuit à 120°C pendant 10 min environ.

On crée ainsi, par cette méthode, un réseau d'éléments résistifs qui est une réplique négative du masque 10.

Pour un élément résistif dont les dimensions sont de 15 mm x 5 mm, la résistance électrique obtenue est de l'ordre de 10 kohms à 25 kohms selon les conditions opératoires. Ceci correspond à une résistance d'environ 3 à 8 kohms/carré.

On peut également réaliser un réseau d'éléments résistifs qui est une image positive d'un masque comme illustré sur les parties a et b de la figure 2.

Dans ce cas, on dépose sur le circuit intégré 2 (partie a de la figure 2) un film mince 9 d'un polymère peu ou pas conducteur contenant un composé photosensible apte à engendrer un dopant du polymère le rendant conducteur. Ce polymère est un polymère soluble du type polypyrrole, polythiophène, polyaniline, polyphényle et leur dérivés, obtenu par polymérisation d'un monomère correspondant selon la technique décrite par exemple dans Ten K.Y., Miller G.G. and Elesembaumer R.L.J., Chem. Soc. Chem. Commun, 1986, p.1346.

On insole alors le film 9 de polymère à travers le masque 12 représentant l'image positive du réseau résistif à réaliser. Les zones isolées 9a se dopent et deviennent conductrices alors que les zones masquées 9b restent quasi-isolantes (partie b de la figure 2). On effectue ensuite le recuit de stabilisation du réseau résistif obtenu.

### EXEMPLES

La méthode décrite en référence à la figure 2 peut être mise en oeuvre avec du poly(octyl-3 thiophène) soluble contenant des sels de Crivello ou sels d'oniums de type φ₃SAsF₆, φ₂IAsF₆ ou φ₃SCF₃SO₃ où φ représente un noyau benzénique.

On effectue donc le dépôt à la tournette de poly(octyl-3 thiophène) dissous dans du dichlorométhane contenant un sel de Crivello, sur le circuit intégré. On effectue alors l'insolation 8 du film 9 de polymère avec une lampe haute pression à vapeur de mercure à travers le masque 12.

Sous l'action de la lumière ultraviolette, le sel donne naissance dans les zones 9a à un acide fort du type HAsF₆ ou CF₃SO₃H qui dope le poly(octyl-3 thiophène) et le rend conducteur. Le polymère non dopé est rouge alors que le polymère dopé dans les zones insolées est bleu. Un recuit à 120°C pendant 10 min est alors effectué.

Les conditions de dépôt et d'insolation du film 9 utilisées sont les mêmes que celles du film 6.

Ce type de procédé a été proposé dans l'article (3) cité précédemment.

On peut aussi utiliser cette méthode avec de la polyaniline soluble comme décrit dans l'article (5) de M. Angelopoulos, J.M. Shaw et J.J. Ritsko, Science and application of conducting polymers, édité par W.R. Salaneck, D.T. Clark et E.J. Samuelsen (1990) pp.63-72, "Applications of conducting polymers in computer manufacturing".

## Revendications

1. Procédé de fabrication d'un réseau d'éléments résistifs sur un support, consistant à photostructurer sur le support (2) un polymère organique localement dopé par un anion et conducteur électronique (6a, 9a).

2. Procédé selon la revendication 1, caractérisé en ce qu'on oxyde chimiquement et localement en présence d'un dopant au moins un monomère apte à former ledit polymère conducteur.

3. Procédé selon la revendication 1 ou 2, caractérisé en ce qu'il comprend les étapes suivantes :
a)- dépôt sur le support d'un polymère organique hôte (6) contenant un agent oxydant photoréductible,
b)- insolation (8) du polymère à travers un masque (10) définissant l'emplacement et la forme des éléments, réduisant ainsi l'oxydant dans les zones du polymère insolées (6b), et
c)- mise en contact du polymère hôte insolé avec au moins un monomère polymérisable et oxydable chimiquement par ledit agent, afin de rendre les zones du polymère non insolées (6a), conductrices.

4. Procédé selon la revendication 3, caractérisé en ce que l'étape c consiste à mettre le polymère hôte insolé au contact de vapeurs dudit monomère polymérisable.

5. Procédé selon la revendication 3, caractérisé en ce que l'étape c consiste à tremper le polymère hôte insolé dans une solution dudit monomère polymérisable.

6. Procédé selon l'une quelconque des revendications 3 à 5, caractérisé en ce que le polymère hôte est choisi parmi le chlorure de polyvinyle, le copolymère de chlorure de vinyle et d'acétate de vinyle, le polyvinylalcool ou poly(oxyléthylène).

7. Procédé selon l'une quelconque des revendications 3 à 6, caractérisé en ce que l'oxydant photoréductible est un sel ferrique ou un sel cérique.

8. Procédé selon la revendication 1 ou 2, caractérisé en ce qu'il comprend les étapes suivantes :
A) dépôt sur le support d'un polymère (9) dopé apte à conduire électroniquement et contenant un composé photosensible apte à engendrer un dopant de ce polymère,
B) insolation (8) du polymère dopé apte à conduire à travers un masque (12) définissant l'emplacement et la forme des éléments, engendrant ainsi le dopant dans les zones du polymère insolées (9a) et les rendant conductrices.

9. Procédé selon la revendication 8, caractérisé en ce que le polymère (9) apte à conduire contient des sels de Crivello (sels d'oniums).

10. Procédé selon l'une quelconque des revendications 3 à 9, caractérisé en ce que l'insolation (8) est effectuée avec de la lumière ultraviolette.

11. Procédé selon l'une quelconque des revendications 6 à 10, caractérisé en ce qu'on effectue un recuit du polymère conducteur électronique dopé, obtenu.

12. Procédé selon l'une quelconque des revendications 3 à 11, caractérisé en ce que le dépôt du polymère est effectué selon la technique de la "tournette", le polymère étant alors soluble dans un solvant.

13. Support pourvu d'un réseau d'éléments résistifs, dans lequel les éléments résistifs (6a, 9a) sont réalisés en polymère organique photostructuré, dopé par un anion, conducteur électronique.

14. Support selon la revendication 13, caractérisé en ce que le polymère est un polymère ou un copolymère d'un monomère aromatique et/ou hétérocyclique.

15. Support selon la revendication 13 ou 14, caractérisé en ce que le monomère est choisi parmi le pyrrole, le thiophène, l'aniline, le benzène et leurs dérivés.

16. Support selon l'une quelconque des revendications 13 à 15, caractérisé en ce que le support est un substrat semi-conducteur (2).

17. Support selon l'une quelconque des revendications 13 à 16, caractérisé en ce que le support (2) comporte des bornes conductrices (4) et en ce que les éléments résistifs sont connectés à ces bornes conductrices.

18. Circuit intégré pourvu de bornes conductrices (4) et d'éléments résistifs (6a, 9a) connectés à ces bornes, dans lequel les éléments résistifs (6a, 9a) sont réalisés en polymère organique photostructuré, dopé par un anion, conducteur électronique.

19. Rétine électronique artificielle pourvue de bornes conductrices (4) et d'éléments résistifs (6a, 9a) connectés à ces bornes, dans lequel les éléments résistifs (6a, 9a) sont réalisés en polymère organique photostructuré, dopé par un anion, conducteur électronique.
